# EUROPEAN PATENT APPLICATION

(11) **EP 1 584 703 A1**
(43) Date of publication of application: **12.10.2005**
(21) Application number: 05006227.2
(22) Date of filing: 22.03.2005
(51) Int. Cl.: C23C 14/04

(54) **Mask, method of manufacturing the same, method of forming thin film pattern, method of manufacturing electro-optical device and electronic equipment**

(30) Priority: 23.03.2004 JP 2004084644
(71) Applicant: SEIKO EPSON CORPORATION, Tokyo 163-0811 (JP)
(72) Inventor: Yotsuya, Shinichi, Suwa-shi Nagano-ken 392-8502 (JP); Kuwahara, Takayuki, Suwa-shi Nagano-ken 392-8502 (JP); Ikehara, Tadayoshi, Suwa-shi Nagano-ken 392-8502 (JP)
(74) Representative: HOFFMANN EITLE

(57) **Abstract**

The invention relates to providing a mask that can cope with increasing the size of a region on which a film to be formed and be patterned in high accuracy, a method of manufacturing the same, a method of forming a thin film pattern, a method of manufacturing an electro-optical device, and electronic equipment. A supporting substrate 10, and a plurality of chips 20 attached to the supporting substrate 10 are included. The chip 20 has an opening corresponding to at least a part of shape of a thin film pattern formed on a given surface. The area occupied by the chip 20 is smaller than an area of the thin film pattern using the plurality of chips 20.

## Description

### [Technical Field]

The present invention relates to a mask, a method of manufacturing a mask, a method of forming a thin film pattern, a method of manufacturing an electro-optical device, and electronic equipment.

### [Background]

An organic electroluminescence (EL) panel, which is a kind of electro-optical device, is made up of self-emitting, quick-response display elements having a multilayered structure of thin films. The organic EL panel forms a lightweight display that provides high-speed motion picture response, and thus has drawn great attention recently as the display panel of a flat panel display (FPD) TV, for example. A typical method of manufacturing such an organic EL panel is described in *Applied Physics Letters,* Vol. 51, No. 12: 913-14, 1987. Specifically, a transparent anode electrode made of indium tin oxide (ITO), for instance, is patterned by photolithography in a desired pattern. Then, an organic material is deposited on the pattern with a vacuum evaporator. On top of that, an cathode film of a low work function metal, such as MgAg, is evaporated to form a cathode electrode.
Luminescence elements arranged this way are finally sealed in an inert gas atmosphere so as not to come in contact with moisture or oxygen.

The organic EL panel can emit light of various colors by changing luminescence materials. For example, a technique for forming red, green, and blue color luminescence elements for individual pixels with a thin, highly fine metal mask has been proposed. This technique is to make a metal mask and glass substrate stick together with a magnet and perform evaporation through the mask in order to manufacture a full-color organic EL panel that provides sharp images (see Patent Document 1 below, for example).

To perform evaporation with a mask, a technique for manufacturing an evaporation mask using a silicon substrate has been developed. This method employs semiconductor manufacturing techniques, such as photolithography and dry etching, and develops the silicon substrate into a mask.
Since the thermal expansion coefficient of silicon is almost equal to that of glass, no displacement occurs between the silicon mask and a glass substrate on which a film is deposited due to thermal expansion. In addition, using silicon can enhance processing accuracy (see Patent Document 2 below, for example).
[Patent Document 1] Japanese Unexamined Patent Publication No.2001-273976.
[Patent Document 2] Japanese Unexamined Patent Publication No.2001-185350.

### [Disclosure of the Invention]

### [Problem to Be Solved]

The metal mask described in Patent Document 1 involves the following problem. To increase the panel size for a larger organic EL panel, it is necessary to make the metal mask used for the panel larger correspondingly. It is, however, difficult to manufacture a large and thin metal mask in high accuracy. Furthermore, the thermal expansion coefficient of the metal mask is much larger than that of the glass substrate used for the organic EL panel. Therefore, the metal mask expands much more than the glass substrate because of thermal radiation during the evaporation. As a result, variations due to the thermal expansion accumulate and become considerable when manufacturing a large organic EL panel with the metal mask. It is therefore considered that the metal mask can be used for manufacturing small- or middle-sized panels of about 20 inches at the most.

In addition, the evaporation mask using a silicon substrate described in the Patent Document 2 involves the following problem. Since the diameter of silicon ingot is 300 mm, the size of the silicon substrate is limited up to the diameter of 300 mm. Thus, an evaporation mask cannot be produced that corresponds to the screen size more than this.

Taking the aforementioned situation into account, the present invention aims to provide a mask that can cope with increasing the size of a region on which a film is formed and be patterned in high accuracy, a method of manufacturing the same, a method of forming a thin film pattern, a method of manufacturing an electro-optical device, and electronic equipment.
In addition, the present invention aims to provide a mask that can reduce errors due to a thermal expansion and be patterned by simple process in high accuracy, a method of manufacturing the same, a method of forming a thin film pattern, a method of manufacturing an electro-optical device, and electronic equipment.

### [Means to Solve the Problems]

In order to achieve the aim, a mask according to a first aspect of the present invention includes a supporting substrate, a plurality of chips attached to the supporting substrate. The chip has an opening corresponding to at least a part of shape of a thin film pattern formed on a given surface. An area occupied by the chip is smaller than an area of the thin film pattern formed by using the plurality of chips.
According to the first aspect of the present invention, one mask is formed with a plurality of chips. Thus, a mask can readily be provided by which a thin film pattern larger than the chip (a case where a plurality of thin film patterns forms a large area is included) can be formed. For example, a mask can readily be constructed that can form a large thin film pattern that serves as a component of a widescreen display device.

Also, the mask according to the first aspect of the present invention preferably has the chip made of silicon.
According to the first aspect of the present invention, a mask can readily be formed that has higher mechanical strength such as tensile strength than a metal mask, etc. Thus, in the mask according to the first aspect of the present invention, the thickness of mask can reduce and a mask can readily formed that exhibits a smaller elongation amount with respect to tensile force. Consequently, the mask according to the first aspect of the present invention can form a thin film pattern of a large area in high accuracy and highly precisely. For example, a large thin film pattern that serves as a component of a widescreen display device can be manufactured with high quality and at low cost.
In addition, according to the first aspect of the present invention, if a substrate on which a film is formed is, for example, a silicon substrate, the thermal expansion coefficient of the substrate on which a film is formed can be the same as the thermal expansion coefficient of the mask. Thus, the first aspect of the present invention can provide a mask that can form a thin film pattern in high accuracy without influences of ambient temperatures.

Also, the mask according to the first aspect of the present invention preferably has the chip made of metal.
According to the first aspect of the present invention, for example, if a substrate on which a film is formed is made of metal, the thermal expansion coefficient of the substrate on which a film is formed can be the same as the thermal expansion coefficient of the mask. Thus, the first aspect of the present invention can provide a mask that can form a thin film pattern in high accuracy without influences of ambient temperatures.

Also, the mask according to the first aspect of the present invention preferably has the silicon that has a face orientation (110).
According to the first aspect of the present invention, for example, for silicon that has the face orientation (110), by performing a crystal anisotropic etching in order to form an opening, the etching speed can extremely be reduced. Thus, the etching amount can be controlled in high accuracy. Therefore, the mask according to the first aspect of the present invention has the opening with a high accurate shape and can form a thin film pattern in high accuracy.

Also, the mask according to the first aspect of the present invention preferably has the silicon that has a face orientation (100).
According to the first aspect of the present invention, for example, for silicon that has the face orientation (100), by performing a crystal anisotropic etching, the etching amount can be controlled in high accuracy. Therefore, the mask according to the first aspect of the present invention has the opening with a high accurate shape and can form a thin film pattern in high accuracy.

Also, the mask according to the first aspect of the present invention preferably has the silicon that has a face orientation (111) at a side face of the opening.
According to the first aspect of the present invention, for example, for silicon that has the face orientation (110), the face orientation at the side face of the opening exhibits (111) by performing a crystal anisotropic etching. Since the etching speed can extremely be reduced, the etching amount can be controlled in high accuracy. Therefore, the mask according to the first aspect of the present invention has the opening with a high accurate shape and can form a thin film pattern in high accuracy.

Also, the mask according to the first aspect of the present invention has the chip that has a plurality of the openings. The opening has an elongated hole shape. The plurality of the openings preferably forms a stripe pattern in which longitudinal directions of the elongated hole shapes are disposed in parallel with each other.
With the mask according to the first aspect of the present invention, for example, a thin film pattern that constructs pixels disposed in a stripe pattern can be formed in high accuracy and in a large area. Therefore, the mask according to the first aspect of the present invention can manufacture the stripe pattern that serves as a component of a widescreen display device with high quality and at low cost.

Also, the mask according to the first aspect of the present invention preferably has the chips disposed at an interval from each other.
According to the first aspect of the present invention, since the chips adjacent each other are attached to the supporting substrate at an interval from each other, an alignment of each chip can readily be fine adjusted when thy are attached. Thus, each chip can be attached to the supporting substrate in high accuracy. Also, the first aspect of the present invention can prevent the chips adjacent each other from being broken by touching each other, etc, when they are attached. Further, the mask according to the first aspect of the present invention can prevent the thermal expansion amount of each chip from being accumulated. Thus, a thin film pattern of a large area can be formed with high accurate dimensions.

Also, in the mask according to the first aspect of the present invention, an interval between the chips in a direction perpendicular to a longitudinal direction of the opening having the elongated hole shape of the chip is preferably approximately equal to a width of the elongated hole shape.
According to the first aspect of the present invention, a clearance between the chips is allowed to function as the opening for forming a thin film pattern. Therefore, the mask according to the first aspect of the present invention can manufacture the stripe pattern of a fixed interval with high quality and at low cost.

Also, in the mask according to the first aspect of the present invention, a corner part formed by a side face of the opening of the chip and one plane of the chip preferably has a tapered shape.
According to the first aspect of the present invention, there is no corner in the mask, the corner causing a "shadow" of evaporated particles emitted from an evaporation source. Thus, a thin film pattern can be formed that has an even thickness to an edge part.

Also, in the mask according to the first aspect of the present invention, a thermal expansion coefficient of a material constructing the supporting substrate is preferably approximately equal to a thermal expansion coefficient of a material constructing the chip. Further, in the mask according to the first aspect of the present invention, thermal expansion coefficients of a material constructing the supporting substrate, a material constructing the chip, and a material constructing a member on which a film is formed are preferably approximately same.
According to the first aspect of the present invention, a mask can be provided that can form a thin film pattern in high accuracy without influences of ambient temperatures.

Also, in the mask according to the first aspect of the present invention, the supporting substrate preferably includes an opening region having a rectangular shape. The opening region is preferably provided so as to transect the plurality of chips attached to the supporting substrate.
According to the first aspect of the present invention, for example, by attaching each chip to the supporting substrate so that the opening of the chip is positioned in the opening region of the supporting substrate, the opening of each chip is allowed to function as an opening of the mask. Also, a part of the opening of each chip can be shielded mutually.

Also, in the mask according to the first aspect of the present invention, it is preferable that a longitudinal direction of the opening region of the supporting substrate is approximately perpendicular to the longitudinal direction of the elongated hole shape of the opening of the chip, a plurality of the opening regions are disposed to the supporting substrate in parallel with each other, and the plurality of chips is disposed in one line along one of the opening regions.
In the mask according to the first aspect of the present invention, for example, a stripe pattern can be formed at each of the opening regions. Therefore, the mask according to the first aspect of the present invention can manufacture an electro-optical device made of pixels disposed in a stripe pattern.

Also, in the mask according to the first aspect of the present invention, the supporting substrate preferably has a plurality of alignment marks showing an attaching position of each of the plurality of chips.
According to the first aspect of the present invention, each chip can be attached at a desired position of the supporting substrate. Thus, a mask can readily be provided that has a large area and high accuracy.

Also, in the mask according to the first aspect of the present invention, the supporting substrate is preferably constructed by combining a plurality of quadrangular prisms.
According to the first aspect of the present invention, a supporting substrate can readily be constructed that has a desired size and shape. Thus, a mask can readily be provided that has a large area and high accuracy.

In order to achieve the aforementioned aim, a method of forming a thin film pattern according to a second aspect of the present invention includes a step of forming a thin film pattern using a mask. In the mask, a plurality of chips is attached to the substrate. Each of the plurality of chips has an opening corresponding to at least a part of a shape of the thin film pattern to be formed on a given surface. The area of the thin film pattern is larger than the area occupied by the chip.
According to the second aspect of the present invention, a large thin film pattern can readily be formed in high accuracy with one large mask constructed with a plurality of chips. Therefore, the second aspect of the present invention, for example, can readily form a large thin film pattern in high accuracy, the pattern serving a component of a widescreen display device.

Also, in the method of forming a thin film pattern according to the second aspect of the present invention, it is preferable that after forming a part of the thin film pattern on the given surface using one of the mask, another part of the thin film pattern is formed by forming a film again on the given surface using the mask whose position has been shifted with respect to the given surface.
According to the second aspect of the present invention, in a case where the same pattern is repeatedly formed entirely on a given surface such as, for example, a pixel arrangement in a display device, a film is formed on a part of the given surface by the first forming using the mask. Then, a film can be formed on another part of the given surface by the second (or the third) forming using the same mask. Therefore, in the second aspect of the present invention, a large thin film pattern can be formed at low cost using a mask that has a construction of simple and easy to make.

Also, in the method of forming a thin film pattern according to the second aspect of the present invention, a distance of shifting the position of the mask is preferably a distance corresponding to a size of the opening.
According to the second aspect of the present invention, in a case where the same pattern is repeatedly formed entirely on a given surface such as, for example, a pixel arrangement in a display device, a film can be formed to pixels of the first, third, fifth, etc., rows (odd-numbered rows) by the first forming using the mask. Then, a film can be formed to pixels of the second, fourth, sixth, etc., rows (even-numbered rows) by the second (or the third) forming using the same mask. Therefore, in the second aspect of the present invention, a large thin film pattern can be formed at low cost and in high accuracy using a mask that has a construction of simple and easy to make.

Also the method of forming a thin film pattern according to the second aspect of the present invention, it is preferable that a plurality kinds of the masks each of which an attaching position of the plurality of the chips with respect to a given surface is shifted is prepared, and one thin film pattern is formed using the plurality kinds of the masks individually.
According to the second aspect of the present invention, for example, a film can be formed on a part of a given surface by the first forming using the first mask among the plurality kinds of masks, and a film can be formed on another part of the given surface by second (or third) forming using the second mask among the plurality kinds of masks.
Therefore, in the second aspect of the present invention, a large thin film pattern can be formed at low cost and in high accuracy using a mask that has a construction of simple and easy to make.

Also, in the method of forming a thin film pattern according to the second aspect of the present invention, a shifted value of the attaching position of the chip among the masks is preferably a value corresponding to a size of the opening.
According to the second aspect of the present invention, in a case where the same pattern is repeatedly formed entirely on a given surface such as, for example, a pixel arrangement in a display device, thin film patterns adjacent each other can be formed by the first forming and the second forming, in both of which the same mask is used. For example, in a case where a film is formed to pixels of the first, third, fifth, etc., rows (odd-numbered rows) by the first forming using the mask, and a film is formed to pixels of the second, fourth, sixth, etc., rows (even-numbered rows) by the second (or third) forming using the same mask, an interval between a pixel of odd-numbered row and a pixel of even-numbered row can be constant or can be eliminated. Therefore, in the second aspect of the present invention, a large thin film pattern can be formed at low cost and in high accuracy using a mask that has a construction of simple and easy to make.

In order to achieve the aforementioned aim, a method of manufacturing a mask for forming a thin film pattern according to a third aspect of the present invention includes the following steps: a step of forming a plurality of chips, the chip having an opening corresponding to a part of a shape of a thin film pattern to be formed on a given surface, an area of the chip being smaller than an area of the thin film pattern serving as a film to be formed; and a step of attaching the plurality of chips to a supporting substrate.
According to the third aspect of the present invention, one mask can be constructed with a plurality of chips. Therefore, in the third aspect of the present invention, a mask can readily be provided by which a thin film pattern larger than the chip (a case where a plurality of thin film patterns forms a large area is included) can be formed. For example, a mask can readily be constructed that can form a thin film pattern of a large area that serves as a component of a widescreen display device. Also, the mask manufactured by the method according to the third aspect of the present invention can prevent the thermal expansion amount of each chip from being accumulated. Thus, a thin film pattern of a large area can be formed with high accurate dimensions.

Also, in the method of manufacturing a mask for forming a thin film according to the third aspect of the present invention, an opening of the chip is preferably formed using crystal anisotropic etching.
According to the third aspect of the present invention, the shape of the opening of the chip can be processed in high accuracy.

Also, in the method of manufacturing a mask for forming a thin film pattern according to the third aspect of the present invention, the chip is preferably made of silicon having a face orientation (110). The opening of the chip is preferably formed by the following steps: forming an antietching mask material on an entire exposed face of the silicon; forming a hole to the antietching mask material formed at one face side of the chip so that the hole corresponds to a shape of the opening and a longitudinal direction of the opening is perpendicular to a face direction (111) of the silicon, removing simultaneously a region including the opening from the antietching mask material formed at the other face side of the chip; and forming a through hole in the chip by the crystal anisotropic etching.
According to the third aspect of the present invention, the opening can be provided by performing a crystal anisotropic etching from both one face and the other face of the chip. In addition, according to the third aspect of the present invention, the side face in the longitudinal direction of the opening serves as the face orientation (111), because the crystal anisotropic etching is performed so that the face orientation (111) is at right angles to the longitudinal direction of the opening in the silicon wafer that has the face orientation (110). Accordingly, in the crystal anisotropic etching, the etching ratio between the depth direction of the opening and the side face in the longitudinal direction of the opening can be, for example 1:1000, thereby enabling the width dimension of the opening to be controlled in high accuracy.

In order to achieve the aforementioned aim, a method of manufacturing an electro-optical device according to a fourth aspect of the present invention uses the mask or the method of forming a thin film pattern when a thin film pattern that serves as a construction layer of an electro-optical device is formed.
According to the fourth aspect of the present invention, a large thin film pattern can readily be formed in high accuracy, the pattern serving as a component of an electro-optical device that has a widescreen. Thus, an electro-optical device can be provided at low cost, the device being able to display high quality image without unevenness as a widescreen that has an excellent distribution of film thickness of each pixel.

In order to achieve the aforementioned aim, electronic equipment according to a fifth aspect of the present invention is manufactured using the mask or the method of forming a thin film pattern.
According to the fifth aspect of the present invention, for example, electronic equipment can be provided at low cost, the equipment being able to display a bright large image without unevenness as a widescreen. Also, according to the fifth aspect of the present invention, electronic equipment can be provided at low cost, the equipment including an electronic circuit made of a thin film that is highly precisely patterned to an entire substrate of a large area.

### [Brief Description of the Drawings]

FIG. 1 is a schematic perspective view showing a mask according to an embodiment of the present invention.
FIG. 2 is a diagram illustrating an array example of pixel pattern formed with the mask.
FIG. 3 is a partially enlarged perspective view of the mask.
FIG. 4 is a plan view illustrating an example of evaporated pattern formed by using the mask.
FIG. 5 is a plan view illustrating an example of evaporated pattern formed by using the mask.
FIG. 6 is a plan view illustrating an example of evaporated pattern formed by using the mask.
FIG. 7 is a schematic sectional view illustrating a method of manufacturing the mask.
FIG. 8 is a schematic perspective view illustrating an example of a method of manufacturing a supporting substrate of the mask.
FIG. 9 is a schematic perspective view illustrating an example of a method of manufacturing a supporting substrate of the mask.
FIG. 10 is a schematic sectional view illustrating a method of manufacturing an electro-optical device according to another embodiment of the present invention.
FIG. 11 is a schematic sectional view illustrating a method of forming a film of a luminescence material according to the embodiment of the present invention.
FIG. 12 is a schematic sectional view illustrating an organic EL device manufactured by the method of manufacturing.
FIG. 13 is a perspective view illustrating electronic equipment according to another embodiment of the present invention.

### [Description of Preferred Embodiments]

A mask according to embodiments of the present invention will be described below with reference to accompanying drawings.

### (Mask Construction)

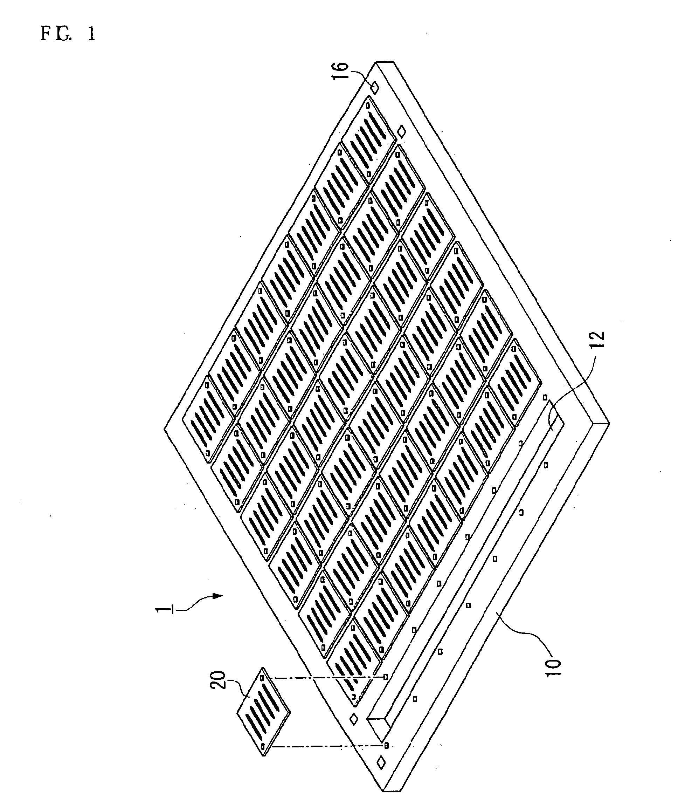

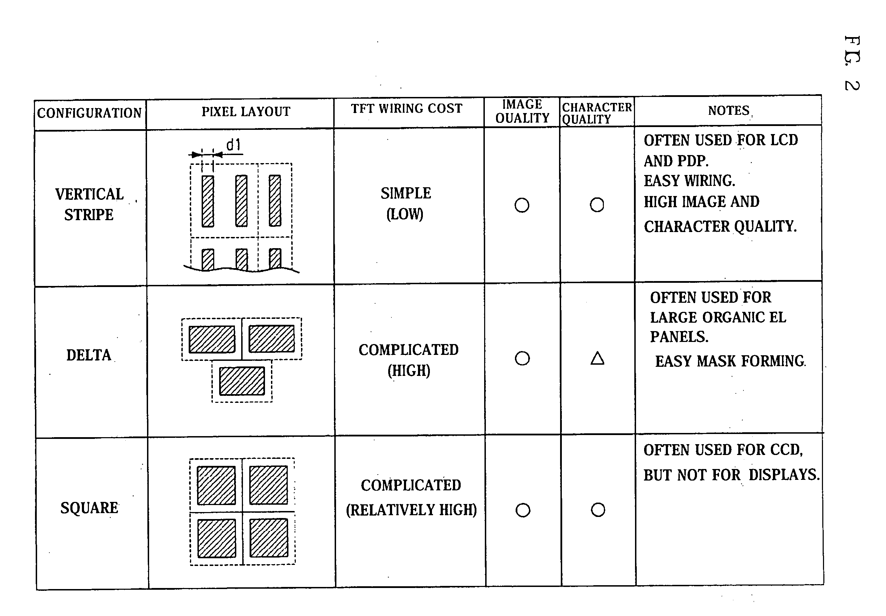

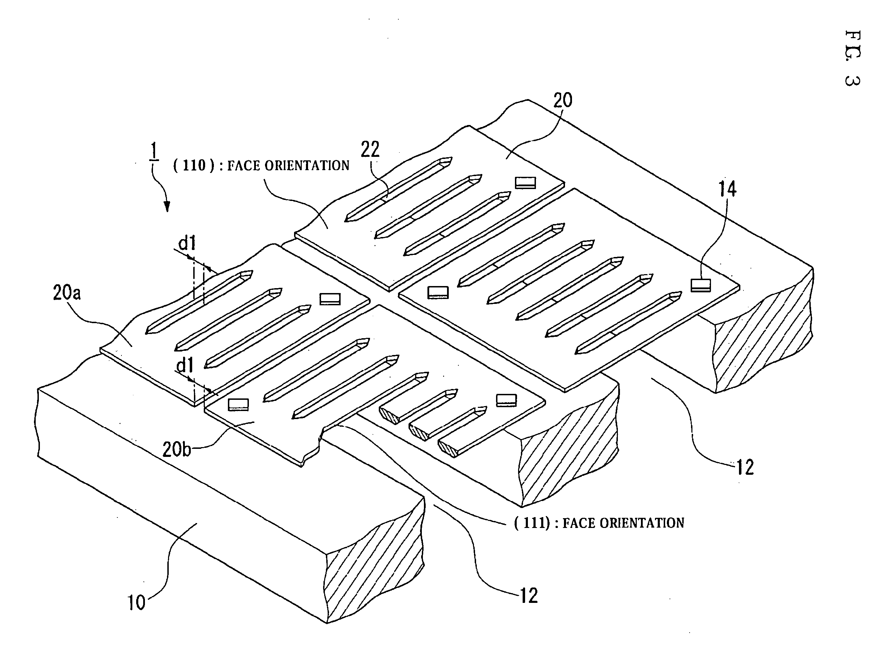

FIG. 1 is a schematic perspective view illustrating a mask according to an embodiment of the present invention. FIG. 2 is a diagram illustrating an array example of pixel pattern formed with the mask shown in FIG. 1 FIG. 3 is a partially enlarged perspective view of the mask shown in FIG. 1. A mask 1 according to the embodiment can be used as, for example, an evaporation mask.

The mask 1 has the construction in which a plurality of chips 20 is provided to a supporting substrate 10 that serves as a base substrate. In the embodiment, the chip 20 is made of silicon. The chip 20 also can be made of metal. Each chip 20 is adhesively bonded to the supporting substrate 10 with an individual alignment. Also, a mask positioning mark 16 is formed to the supporting substrate 10. The mask positioning mark 16 is for the purpose of positioning the mask 1 when evaporation, etc., is performed using the mask 1. The mask positioning mark 16 can be formed, for example, with a metal film. Meanwhile, the mask positioning mark 16 may be formed to the chip 20.

As shown in FIG. 1 and FIG. 3, a plurality of opening regions 12 of a through hole whose opening part is rectangular is disposed on the supporting substrate 10 in parallel with each other at a fixed interval. As shown in FIG. 3, a plurality of openings 22 each of which is elongated shape is disposed on the chip 20 in parallel with each other at a fixed interval. Each shape of the openings 22 of the chip 20 corresponds to a thin film pattern that serves as a pixel arrangement of "vertical stripe" shown in FIG. 2. Therefore, the mask 1 is used in order to form pixels of the vertical stripe.

Each chip 20 is disposed in rows and columns on the supporting substrate 10 so that the chip 20 closes up the opening region 12 of the supporting substrate 10 and the longitudinal direction of the opening region 12 is perpendicular to the longitudinal direction of the opening 22 of the chip 20.

It is preferable that a material constructing the supporting substrate 10 has a thermal expansion coefficient that is the same as or close to that of the material constructing the chip 20. Since the chip 20 is silicon, the supporting substrate 10 is constructed with a material whose thermal expansion coefficient is the same as or close to that of silicon. By doing this, an occurrence of "strain" or "bending" can be suppressed that is caused by the difference in a thermal expansion amount between the supporting substrate 10 and the chip 20. For example, with respect to the thermal expansion coefficient of silicon (30x10E-7/degrees Celsius), the thermal expansion coefficient of Pyrex (registered trademark) of Coming Incorporated (30x10E-7/degrees Celsius) is the nearly the same value. The following materials show a thermal expansion coefficient close to that of silicon: the thermal expansion coefficient of OA-10 of Nippon Electric Glass, which is alkali-free glass, (38x10E-7/degrees Celsius); and metal, the thermal expansion coefficient of alloy 42 (50x10E-7/degrees Celsius) and the thermal expansion coefficient of invar (12x10E-7/degrees Celsius), etc. Thus, Pyrex (registered trademark) glass, OA-10 that is alkali-free glass, and alloy 42, etc., can be applied to the material constructing the supporting substrate 10.

The chip 20 is constructed in which the opening 22 is provided to a rectangular plate as shown in FIG. 3.
Since the mask 1 of the embodiment is the purpose of forming the pixels of "vertical stripe" shown in FIG. 2, the opening 22 of the chip 20 has, for example, a slotted groove shape whose size is corresponding to a region including row of approximately 40 vertical pixels. That is, the opening 22 of the chip 20 has a shape corresponding to at least one part of the shape of a thin film pattern to be formed on a given surface. The area occupied with the chip 20 is smaller than the area of the thin film pattern (e.g. a thin film pattern constructing an organic electroluminescence (EL) panel) formed with the mask 1.

Silicon that serves as the chip 20 of the embodiment has a face orientation (110). However, the chip 20 may be made of silicon that has a face orientation (100). The side face extended in the longitudinal direction of the opening 22 of the chip 20 has a face orientation (111). The face orientation (111) shown on the side face of the opening 22 can readily be realized by performing a crystal anisotropic etching to the silicon chip that has the face orientation (110).

In each chip 20, an alignment mark 14 is formed at least two parts. The alignment mark 14 is used for positioning the chip 20 to the supporting substrate 10 when two are bonded. The alignment mark 14 is formed by means of photolithography or crystal anisotropic etching, etc.

Each chip 20 is attached to the supporting substrate 10 so that the longitudinal direction of the opening 22 of the chip 20 is perpendicular to the opening region 12 of the supporting substrate 10. The width of the opening 22 is set, for example, to be the same as a sub-pixel-pitch d1 of pixels. Chips 20a and 20b are disposed with an interval of the sub-pixel-pitch d1 of pixels. The chips 20a and 20b close up the same opening region 12 and are adjacent each other. The clearance between the chips 20a and 20b functions, in a similar way of the opening 22 of the chip 20, as an opening of the mask 1 for forming a thin film pattern with a desired shape. In addition, the chips 20 adjacent each other are also disposed with an interval in the direction perpendicular to the longitudinal direction of the opening region 12. The plurality of chips 20 is disposed on the supporting substrate 10 in a matrix with each chip maintaining an interval, as shown in FIG. 1.

In this way, since the plenty of chips 20 is attached on the supporting substrate 10 in the mask 1 of the embodiment, a thin film pattern larger than the chip 20 can be formed. For example, the pixels of the vertical stripe constructing a widescreen display panel can be formed.

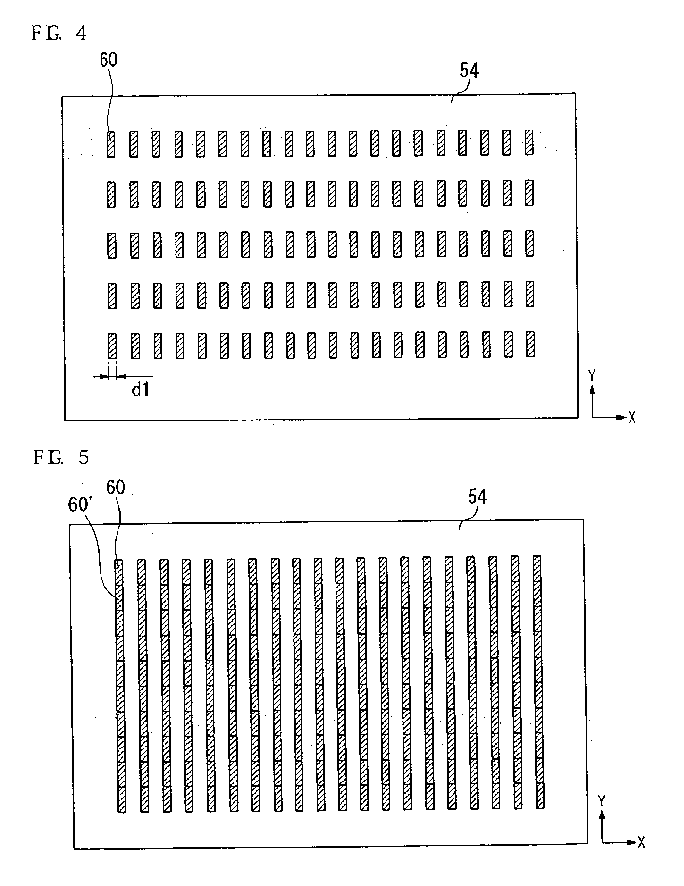

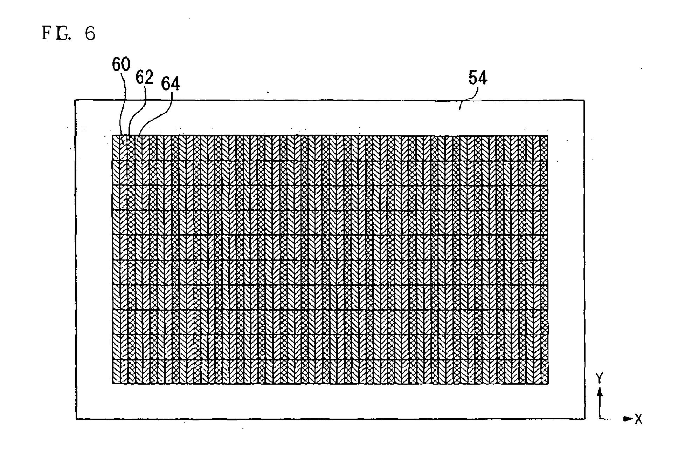

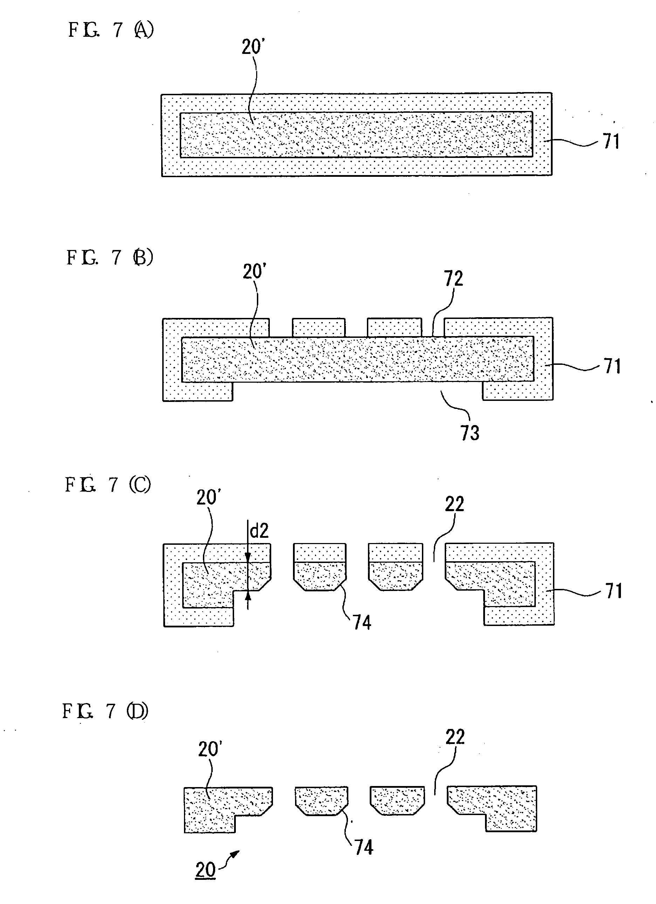

FIG. 4 is a plan view illustrating an example of an evaporated pattern (a thin film pattern) formed using the mask 1 shown in FIG. 1 and FIG. 3. FIG. 5 is a plan view illustrating an example in which evaporation is performed again, after shifting the mask 1, to the substrate on which the evaporated pattern shown in FIG. 4 has been formed. FIG. 6 is a plan view illustrating an example in which evaporation is performed again, after shifting the mask 1, to the substrate on which the evaporated pattern shown in FIG. 5 has been formed.

For the substrate 54 that serves as a member on which the evaporated pattern is formed, transparent substrates such as, for example, a glass substrate that serves as a component of an organic EL device, etc., can be employed. The evaporated pattern in this case is, for example, the stripe pattern that serves as a red color luminescence layer 60 in an organic EL device. Thus, the width of the luminescence layer 60 is the same as the sub-pixel-pitch d1.

However, in the evaporated pattern shown in FIG. 4, pixels in multiple lines (e.g. 40 lines x 5) in red color pixels of an organic EL device are not formed. Therefore, evaporation is performed again after shifting the mask 1 in the up-and-down direction in the figure (the Y-axis direction), for example, by 40 pixels with respect to the substrate 54. As a result, a red color luminescence layer 60' is patterned as shown in FIG. 5. Accordingly, a thin film pattern can readily be formed for a widescreen panel that has a large vertical stripe pattern.

In the evaporated pattern shown in FIG. 5, only the red color luminescence layers 60 and 60' are formed, green color and blue color luminescence layers are not formed. Therefore, a green color luminescence layer 62 is formed as shown in FIG. 6 by patterning a green color luminescence material after shifting the mask 1 in the lateral direction in the figure (the X-axis direction) by one sub-pixel-pitch with respect to the substrate 54 shown in FIG. 5. Then, a blue color luminescence layer 64 is formed as shown in FIG. 6 by patterning a blue color luminescence material after shifting the mask 1 in the lateral direction (the X-axis direction) by one sub-pixel-pitch.

Accordingly, a thin film pattern that serves as a widescreen panel on which colors can be displayed can readily be formed in high accuracy. In the embodiment, a thin film pattern that serves as one widescreen panel is formed by performing evaporation several times in each of which the same mask 1 is shifted. However, the thin film pattern that serves as one widescreen panel may be formed using the mask 1 of several kinds prepared in advance one after the other.

### (Method of Manufacturing Mask)

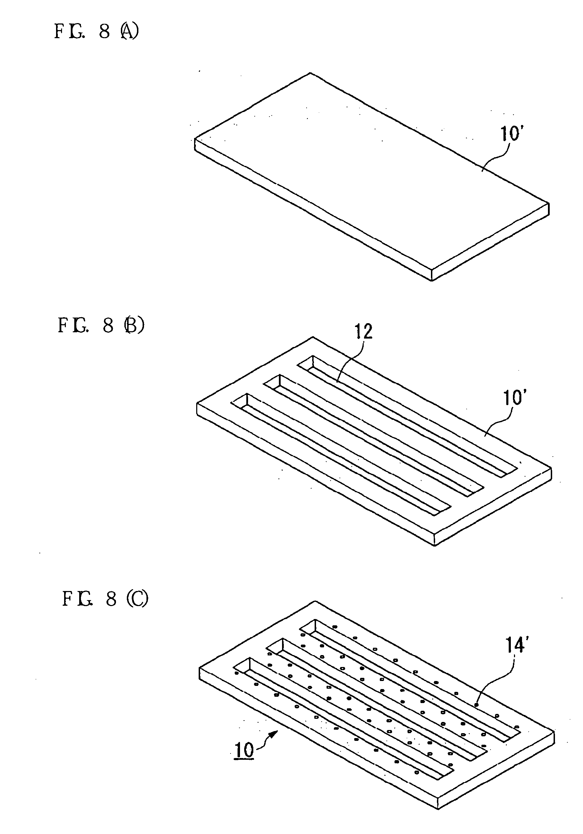

FIG. 7 is a schematic sectional view illustrating a method of manufacturing a mask according to the embodiment of the present invention. That is, FIG. 7 illustrates a method of manufacturing the chip 20 that is made of silicon and serves as a major portion of the mask 1.
Firstly, a silicon wafer 20' that has the face orientation (110) is prepared. Then, a silicon oxide film 71 that serves as an antietching mask material is formed entirely on an exposed surface of the silicon wafer 20' by means of a thermal oxidization method at a thickness of one µm (refer to FIG. 7A).
Any kind of films that have durability in the crystal anisotropic etching performed using an aqueous solution of alkali in later process are eligible for the antietching mask material made of the silicon oxide film 71. Therefore, a silicon nitride film deposited by a CVD method and Au (gold) or Pt (platinum) film or the like deposited by a sputtering method may be employed for the antietching mask material. The antietching mask material is not particularly limited to a silicon oxide film.

Next, a groove pattern 72 is formed that corresponds to an opening shape (shape of cross section) of the opening 22 by patterning the silicon oxide film 71 formed at one face of the silicon wafer 20' using photolithography. Here, the groove pattern 72 is formed so that the face orientation (111) of silicon is at right angles to the longitudinal direction of the groove pattern 72 (refer to FIG. 7B).
The alignment mark 14 may be formed at the same time as the groove pattern 72 is formed.

A region 73 is also removed that is a large region including a part corresponding to the opening 22 by performing photolithography to the silicon oxide film 71 formed at the other face of the silicon wafer 20' at the same time as the groove pattern 72 is formed (refer to FIG. 7B).
In order to reduce a thickness of d2 in a later process, the region 73 is removed that is formed at one face of the silicon wafer 20'. The thickness d2 is a thickness of the region including the opening 22 of the silicon wafer 20'. That is, in order to uniform the thickness of a deposited thin film, the chip 20 formed from the silicon wafer 20' is made thin, so that evaporated particles easily travel through the opening 22 in an oblique direction in evaporation.
For patterning the silicon oxide film 71 using photolithography, for example, a buffered hydrofluoric acid solution is used.

Next, a crystal anisotropic etching is performed to the silicon wafer 20' shown in FIG. 7B using a solution of potassium hydroxide 35 wt % at 80 degrees centigrade. By performing the crystal anisotropic etching, a part of the silicon wafer 20' on which the silicon oxide film 71 does not cover is removed from both one face and the other face, so that a through groove that serves as the opening 22 is formed and the thickness d2 is reduced that is a thickness of the region including the opening 22. Also, by performing the crystal anisotropic etching, a corner 74 located at the region 73 side of the silicon wafer 20' is etched to be a tapered shape (refer to FIG. 7C).

The tapered shape of the corner 74 and the thickness d2 that is a thickness of the region including the opening 22 can be controlled by controlling etching time of the crystal anisotropic etching. Consequently, a favorable mask can be manufactured that a shadow region of the mask 1 is not changed even though the relative position relationship between the mask 1 and an evaporation source is varied.

Finally, the chip 20 of the embodiment is completed by removing the silicon oxide film 71 formed on the silicon wafer 20' (refer to FIG. 7D).
For removing the silicon oxide film 71, for example, a buffered hydrofluoric acid solution is used.

Accordingly, with the method of manufacturing according to the embodiment, the shape of the opening 22 can be processed in high accuracy, because the opening 22 of the chip 20 is formed using a crystal anisotropic etching. In addition, with the method of manufacturing according to the embodiment, the side face in the longitudinal direction of the opening 22 serves as the face orientation (111), because the crystal anisotropic etching is performed so that the face orientation (111) is at right angles to the longitudinal direction of the opening 22 in the silicon wafer 20' that has the face orientation (110). Accordingly, with the crystal anisotropic etching, the etching ratio between the depth direction of the opening 22 and the side face in the longitudinal direction of the opening 22 can be, for example 1:1000, thereby enabling the width dimension of the opening 22 to be controlled in high accuracy.

### (Method of Manufacturing a Supporting Substrate)

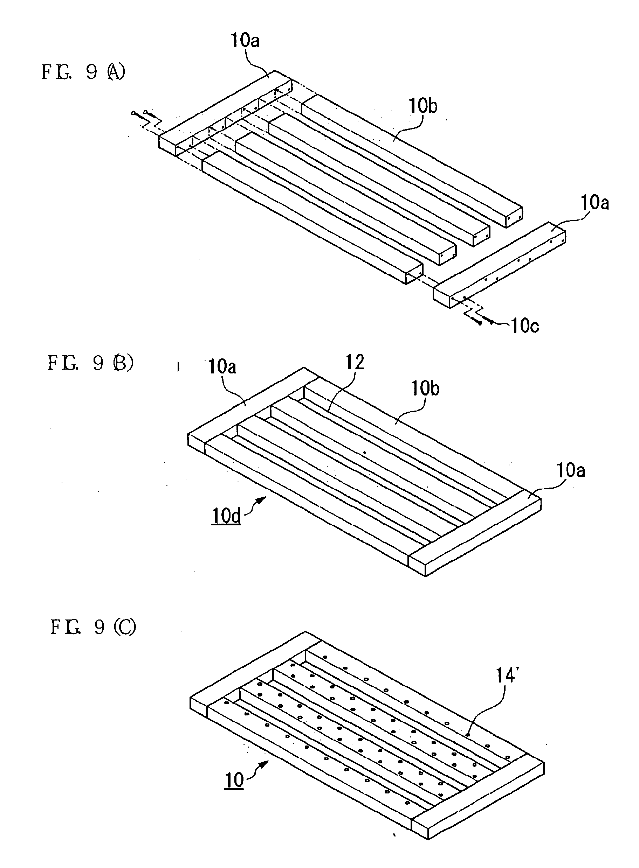

FIG. 8 is a schematic perspective view showing an example of a method of manufacturing a supporting substrate 10 according to the embodiment of the present invention.
Firstly, a substrate 10' is prepared in a desired plate shape for the material that serves the supporting substrate 10 (refer to FIG. 8A).

Next, the opening region 12 that has a rectangular through hole is formed to the substrate 10' in order to allow the chip 20 attached to the supporting substrate 10 to function as a mask (refer to FIG. 8B).
The method according to a material that serves as the supporting substrate 10 can be employed as the method for forming the opening 12. For example, if the substrate 10' is the glass substrate such as alkali-free glass such as Pyrex (registered trademark) glass or OA-10, etc., the opening region 12 is formed by a blasting method, or the opening region 12 is formed by photolithography and wet etching with hydrofluoric acid. In addition, if the supporting substrate 10 is made of metal such as alloy 42 or the like, the following methods may be employed to form the opening region 12: photolithography and wet etching; assembling and manufacturing by welding a plurality of metals; and manufacturing by cutting or casting.

The supporting substrate 10 is completed by additionally forming an alignment mark 14' to the substrate 10 in order to arrange each chip 20 regularly and accurately to the supporting substrate 10 (refer to FIG. 8C).
Photolithography is also used to form the alignment mark 14'. Practically, for example, chromium (Cr) is deposited on the substrate 10' at 50 nm by sputtering. Then, resist is applied on Cr with a spray coating type resist coater. Then, exposure, development, and wet etching of Cr are performed to form the alignment mark 14'. A marking by laser, etc., may also be used as the alignment mark 14'.

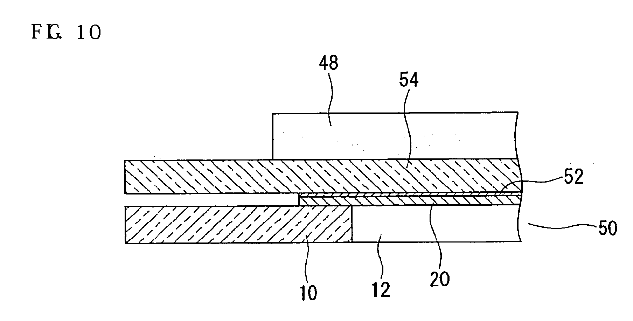

FIG. 9 is a schematic perspective view showing another example of a method of manufacturing a supporting substrate 10 according to the embodiment of the present invention. First, a plurality of quadrangular prisms 10a and 10b are formed that are made of a predetermined material. Then, a substrate 10d that has the opening region 12 is formed by jointing each quadrangular prism 10a and each quadrangular prism 10b with a screw bolt 10C, etc. (refer to FIG. 9A and FIG. 9B).
Each quadrangular prism 10a and each quadrangular prism 10b may be jointed using an adhesive, etc.
Then, the supporting substrate 10 is completed by forming the alignment mark 14' to the substrate 10d (refer to FIG. 9C).

The mask 1 is completed by attaching the chip 20 to the supporting substrate 10 manufactured by means of the above-mentioned methods. Using the mask 1 of the embodiment, as shown in FIG. 6, a thin film pattern can be evaporated that serves as, for example, 40 inches widescreen display device.

### (Method of Manufacturing an Electro-optical Device)

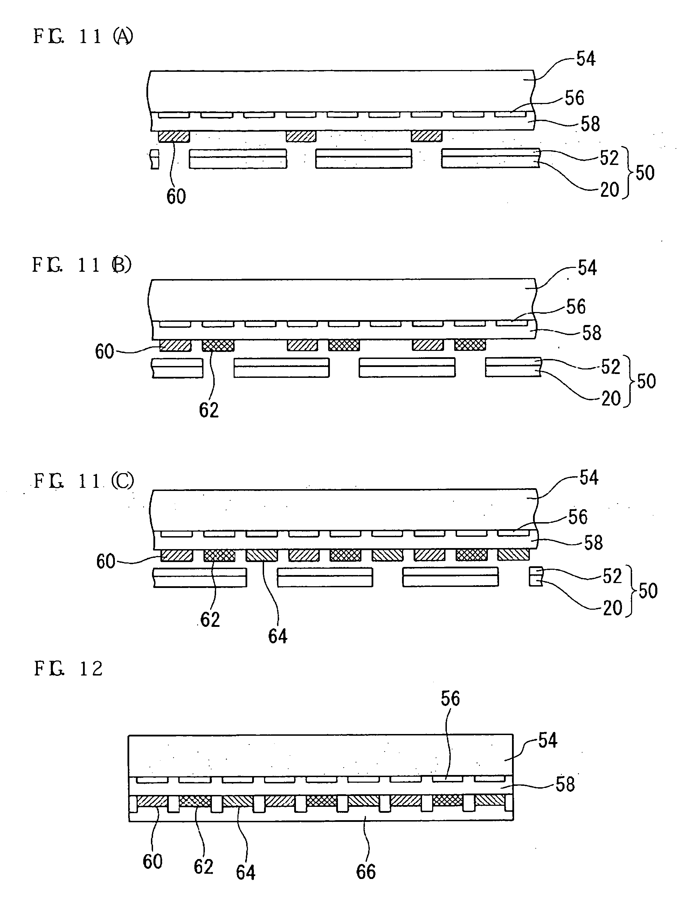

FIG. 10 is a schematic sectional view illustrating a method of manufacturing an electro-optical device according to another embodiment of the present invention.
In the embodiment, an organic EL device will be explained as one of the electro-optical device. A magnetic film 52 is formed on a mask 50 (corresponds to the mask 1) shown in FIG. 10. The magnetic film 52 can be formed with a magnetic material such as iron, cobalt, nickel, etc. Or, the magnetic film 52 may be formed with a magnetic metal such as Ni, Co, Fe, and a stainless steel alloy containing Fe, etc., and by bonding a magnetic metal and a nonmagnetic metal. Other details of the mask 50 are the same as those of the mask 1.

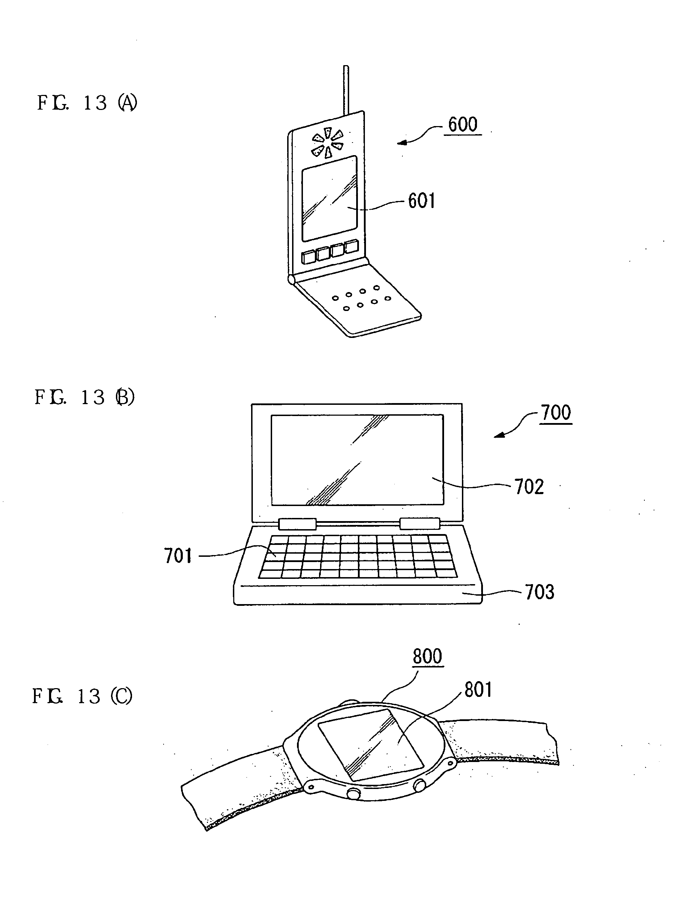

In the embodiment, a luminescence material is formed on a substrate 54 (member on which a film is formed) using the mask 50. The substrate 54 is the purpose of forming a plurality of organic EL devices and made of a transparent substrate such as a glass substrate, etc. As shown in FIG. 11A, an electrode 56 (e.g. a transparent electrode made of ITO, etc.) and a hole transport layer 58 are formed on the substrate 54. Meanwhile, an electron transport layer may be formed.

As shown in FIG. 10, the mask 50 is provided so that the chip 20 is located at the substrate 54 side. A magnet 48 provided at the back of the substrate 54 attracts a magnetic film 52 formed on the mask 50 (the chip 20).

FIGS. 11A through 11C are schematic sectional views explaining a method of forming a film of a luminescence material used for manufacturing an organic EL device. For the luminescence material, organic materials are exemplified as follows: quinolinol-aluminium complex(Alq3) as a low-molecular organic material; and poly para-phenylenevinylene (PPV) as an organic polymer material. A film of a luminescence material can be formed by evaporation.
For example, as shown in FIG. 11A, a red color luminescence layer 60 is formed by depositing and patterning a red color material with the mask 50. Then, as shown in FIG. 11B, a green color luminescence layer 62 is formed by depositing and patterning a green color material after shifting the mask 50. Then, as shown in FIG. 11C, a blue color luminescence layer 64 is formed by depositing and patterning a blue color material after shifting the mask 50 again.

In the embodiment, the chip 20 that serves as a screen is partially adhesive bonded on the supporting substrate 10. Therefore, the chip 20 has a high degree of freedom, a difficulty to develop warpage and bending, high repeatability of selective evaporation, and high productivity. In the mask 50 of the embodiment, a plurality of opening regions 12 is formed to the supporting substrate 10. The chip 20 is positioned corresponding to each opening region 12. A plurality of chips 20 corresponds to one organic EL device. That is, a widescreen organic EL device can be manufactured in high accuracy using the mask 50.

FIG. 12 is a schematic sectional view illustrating a rough construction of an organic EL device manufactured using the above-mentioned method for forming a film of a luminescence material. The organic EL device includes a substrate 54, an electrode 56, a hole transport 58, a luminescence layers 60, 62, 64, etc. An electrode 66 is formed on the luminescence layers 60, 62, 64. The electrode 66 is, for example, a cathode electrode. The organic EL device of the embodiment is preferable to a display device (or display). In the luminescence layers 60, 62, 64, fewer patterns are shifted and a thickness distribution is significantly uniformed, thereby serving a bright widescreen display device without unevenness.

### (Electronic Equipment)

Next, electronic equipment will be explained that is manufactured using the mask of the embodiment.
FIG. 13A is a perspective view showing an example of cellular phones. In FIG. 13A, reference numeral 600 denotes a body of the cellular phone, and reference numeral 601 denotes the display that employs the electro-optical device formed using the mask of the embodiment. FIG. 13B is a perspective view illustrating an example of portable information processing device such as a word processor and a personal computer, etc. Reference numeral 700 in FIG. 13B illustrates a portable information device, reference numeral 701 shows an input part such as a keyboard, etc., reference numeral 703 shows an information processing device body, and reference numeral 702 shows a display unit that employs the electro-optical device formed using the mask of the embodiment. FIG. 13C is a perspective view illustrating an example of wristwatch type electronic equipment. In FIG. 13C, reference numeral 800 denotes a body of the wristwatch, and reference numeral 801 denotes the display that employs the electro-optical device formed using the mask of the embodiment.

The electronic equipment shown in FIG. 13 can display a bright and high quality large image without unevenness as a widescreen and further be manufactured at low cost.

The technical scope of the present invention is not limited to the above embodiments, and various modifications can be applied to the invention without departing from the spirit of the invention. The concrete materials and layer structures listed in the embodiments are only examples, and modification can be appropriately applied thereto. For example, while the mask 1 is used as an evaporation mask in the embodiment, the present invention is not limited to this. The mask 1 can be used as a mask in sputtering or a CVD method.

### [Reference Numerals]

1: mask 10: supporting substrate 10': substrate 10a, 10b: quadrangular prism 10d: substrate 12: opening region 14, 14': alignment mark 16: mask positioning mark 20, 20a, 20b: chip 20': silicon wafer 22: opening 54: substrate 60, 60', 62, 64:luminescence layer 71: silicon oxide film 72: groove pattern 73: region 74: corner

## Claims

1. A mask comprising:
a supporting substrate; and
a plurality of chips attached to the supporting substrate, wherein:
at least one of the plurality of chips includes an opening corresponding to at least a part of shape of a thin film pattern formed on a given surface; and
an area occupied by the chip is smaller than an area of the thin film pattern formed by using the plurality of chips.

2. The mask according to claim 1, wherein the chip is made of silicon.

3. The mask according to claim 1, wherein the chip is made of metal.

4. The mask according to claim 2, wherein the silicon has a face orientation (110).

5. The mask according to claim 2, wherein the silicon has a face orientation (100).

6. The mask according to claim 2, wherein a side face of the opening of the silicon has a face orientation (111).

7. The mask according to any one of claims 1 through 6, wherein the chip includes a plurality of the openings at least one of which has an elongated hole shape, and the plurality of the openings form a stripe pattern in which a longitudinal direction of the elongated hole shape is disposed in parallel with each other.

8. The mask according to any one of claims 1 through 7, wherein the chips are disposed at an interval from each other.

9. The mask according to claim 8, wherein an interval between the chips in a direction perpendicular to a longitudinal direction of at least one of the openings at least one of which has the elongated hole shape of the chip is approximately equal to a width of the elongated hole shape.

10. The mask according to any one of claims 1 through 9, wherein a corner part formed by a side face of the opening of the chip and one plane of the chip has a tapered shape.

11. The mask according to any one of claims 1 through 10, wherein a thermal expansion coefficient of a material constructing the supporting substrate is approximately equal to a thermal expansion coefficient of a material constructing the chip.

12. The mask according to any one of claims 1 through 10, wherein thermal expansion coefficients of the material constructing the supporting substrate, the material constructing the chip, and a material constructing a member on which a film to be formed are approximately same.

13. The mask according to any one of claims 1 through 12, wherein the supporting substrate includes an opening region having a rectangular shape, and the opening region is provided so as to transect the plurality of chips attached to the supporting substrate, wherein the opening region includes at least a plurality of opening regions.

14. The mask according to claim 13, wherein a longitudinal direction of the opening region of the supporting substrate is approximately perpendicular to the longitudinal direction of the elongated shape of the opening of the chip, and the plurality of the opening regions are disposed to the supporting substrate in parallel with each other, the plurality of chips is disposed in one line along one of the opening regions.

15. The mask according to any one of claims 1 through 14, wherein the supporting substrate includes a plurality of alignment marks showing an attaching position of each of the plurality of chips.

16. The mask according to any one of claims 1 through 15, wherein the supporting substrate is constructed by combining a plurality of quadrangular prisms.

17. A method of forming a thin film pattern comprising:
forming a thin film pattern using a mask that includes a plurality of chips attached to a supporting substrate, wherein each of the plurality of chips has an opening corresponding to at least a part of a shape of the thin film pattern to be formed on a given surface, and an area of the thin film pattern is larger than an area occupied by the chip.

18. The method of forming a thin film pattern according to claim 17, further comprising:
shifting a position of the mask with respect to the given surface; and
forming another part of the thin film pattern by forming a film again on the given surface using the mask.

19. The method of forming a thin film pattern according to claim 18, wherein a distance by which the mask is shifted is a distance corresponding to a size of the opening.

20. The method of forming a thin film pattern according to claim 17, wherein a plurality kinds of the masks each of which an attaching position of the plurality of the chips with respect to the given surface is shifted is prepared, and the thin film pattern is formed using the plurality kinds of the masks individually.

21. The method of forming a thin film pattern according to claim 20, wherein a shifted value of the attaching position of the chip among the masks is a value corresponding to a size of the opening.

22. A method of manufacturing a mask for forming a thin film pattern comprising:
forming a plurality of chips; and
attaching the plurality of chips to a supporting substrate, wherein at least one of the plurality of chips has an opening corresponding to a part of a shape of the thin film pattern to be formed on a given surface, and an area of the chip is smaller than an area of the thin film pattern serving as a film to be formed.

23. The method of manufacturing a mask for forming a thin film pattern according to claim 22, wherein the opening of the chip is formed using crystal anisotropic etching.

24. The method of manufacturing a mask for forming a thin film pattern according to claim 23, wherein the step of forming the opening of the chip made of silicon having a face orientation (110) comprises:
forming an antietching mask material on an entire exposed face of the silicon;
forming a hole to the antietching mask material formed at one face side of the chip so that the hole corresponds to a shape of the opening and a longitudinal direction of the opening is perpendicular to a face direction (111) of the silicon;
removing simultaneously a region including the opening from the antietching mask material formed at the other face side of the chip; and
forming a through hole in the chip by the crystal anisotropic etching.

25. A method of manufacturing an electro-optical device comprising using at least one of the mask according to any one of claims 1 through 16, the method of manufacturing a thin film pattern according to any one of claims 17 through 21, and the mask manufactured by the method of manufacturing a mask for forming a thin film pattern according to any one of claims 22 through 24.

26. An electronic equipment manufactured using at least one of the mask according to any one of claims 1 through 16, the method of manufacturing a thin film pattern according to any one of claims 17 through 21, and the mask manufactured by the method of manufacturing a mask for forming a thin film pattern according to any one of claims 22 through 24.
